# EUROPÄISCHE PATENTANMELDUNG

(11) **EP 0 803 913 A1**
(43) Veröffentlichungstag der Anmeldung: **29.10.1997**
(21) Anmeldenummer: 97106595.8
(22) Anmeldetag: 21.04.1997
(51) Int. Cl.: H01L 29/872, H01L 29/06, H01L 21/329

(54) **Schottkydiodenanordnung und Verfahren zur Herstellung**

(30) Priorität: 25.04.1996 DE 19616605
(71) Anmelder: SIEMENS AKTIENGESELLSCHAFT, 80333 München (DE)
(72) Erfinder: Losehand, Reinhard, 80637 München (DE); Werthmann, Hubert, 81247 München (DE)

(57) **Zusammenfassung**

Die Erfindung bezieht sich auf eine Schottkydiodenanordnung mit einem auf einem Halbleitersubstrat (2) ausgebildeten Schottkykontakt (3) bestehend aus einem Halbleiterbereich (4) eines ersten Leitungstyps und einer auf dem Halbleiterbereich (4) angrenzend angeordneten Metallschicht (5), sowie einer am Randbereich (6) des Schottkykontaktes (3) ausgebildeten Schutzstruktur (7) mit einem im Halbleitersubstrat (2) ausgebildeten Dotierbereich (8) eines zweiten Leitungstyps entgegengesetzter Polarität zum ersten Leitungstyp, welcher Dotierbereich (8) sich ausgehend von einer Hauptoberfläche (9) des Halbleitersubstrates (2) in eine vorbestimmte Tiefe in das Halbleitersubstrat (2) erstreckt. Der Dotierbereich (8) der Schutzstruktur (7) weist wenigstens zwei gegenüber der Hauptoberfläche (9) des Halbleitersubstrats (2) untereinander liegende, unterschiedliche erste und zweite Dotierabschnitte (15, 16) auf, wobei der erste Dotierabschnitt (15) in größerer Tiefe ausgebildet ist und eine vergleichsweise geringere Dotierung besitzt, und der zweite Dotierabschnitt (16) eine vergleichsweise hohe Dotierung aufweist und bis zu einer geringen Tiefe angrenzend an die Hauptoberfläche (9) des Halbleitersubstrates (2) ausgebildet ist.

## Beschreibung

Die Erfindung bezieht sich auf eine Schottkydiodenanordnung mit einem auf einem Halbleitersubstrat ausgebildeten Schottkykontakt bestehend aus einem Halbleiterbereich eines ersten Leitungstyps und einer auf dem Halbleiterbereich angrenzend angeordneten Metallschicht, sowie einer am Randbereich des Schottkykontaktes ausgebildeten Schutzstruktur mit einem im Halbleitersubstrat ausgebildeten Dotierbereich eines Zweiten Leitungstyps entgegengesetzter Polarität zum ersten Leitungstyp, welcher Dotierbereich sich ausgehend von einer Hauptoberfläche des Halbleitersubstrates in eine vorbestimmte Tiefe in das Halbleitersubstrat erstreckt. Die Erfindung bezieht sich des weiteren auf ein Verfahren zur Herstellung einer solchen Schottkydiodenanordnung.

Zur Verbesserung der Sperreigenschaften einer Schottkydiode ist es bekannt, am Randbereich des Metall-Halbleiter-Übergangs einen zur Leitfähigkeit des Halbleiterbereichs der Diode entgegengesetzt dotierten Schutzring einzudiffundieren; hierdurch entsteht am Diodenrand ein graduierter pn-Übergang, wodurch Leckströme verringert werden können. Im Falle einer n-dotierten Siliziumepitaxieschicht für den Diodenhalbleiterbereich ist der Schutzring p-leitend. Durch diese Maßnahme gelingt es, die Sperrströme einer Schottkydiode gleichmäßig über die Produktion der Diode und auf dem für einen vorbestimmten Diodentyp niedrigsten Niveau einzustellen. Zur Optimierung der Durchbruchspannung bei einem vorbestimmten Diodentyp sollte die Dotierung des Schutzrings möglichst niedrig und tief diffundiert sein, jedoch oberhalb dem Niveau der Epitaxiedotierung liegen, damit der pn-Übergang wirksam ist. Eine niedrige Schutzringdotierung an der Grenzfläche zu dem benachbart zum Metall-Halbleiter-Kontakt angeordneten Dielektrikum verstärkt jedoch die Gefahr einer Kanalbildung an dieser Grenzfläche, welche eine Erhöhung des Sperrstromes der Diode und der Kapazität zur Folge hat.

Der vorliegenden Erfindung liegt die Aufgabe zugrunde, den Schutzring bei einer Schottkydiodenanordnung dahingehend zu verbessern, daß das Durchbruchverhalten der Diode verbessert ist, und gleichzeitig die Gefahr einer Kanalbildung an der Grenzfläche zum Dielektrikum des Schutzringes wirksam verhindert werden kann.

Diese Aufgabe wird durch die Schottkydiodenanordnung nach Anspruch 1 gelöst. Das Verfahren zur Herstellung einer solchen Schottkydiodenanordnung ist im Anspruch 11 angegeben.

Erfindungsgemäß ist vorgesehen, daß der Dotierbereich der Schutzstruktur wenigstens zwei gegenüber der Hauptoberfläche des Halbleitersubstrats untereinander liegende, unterschiedliche erste und zweite Dotierabschnitte aufweist, wobei der erste Dotierabschnitt in größerer Tiefe ausgebildet ist und eine vergleichsweise geringere Dotierung besitzt, und der zweite Dotierabschnitt eine vergleichsweise hohe Dotierung aufweist und bis zu einer geringen Tiefe angrenzend an die Hauptoberfläche des Halbleitersubstrates ausgebildet ist. Dem Prinzip der Erfindung folgend ist hierbei vorgesehen, daß der erste Dotierabschnitt durch Implantation eines Dotiermittels mit vergleichsweise geringer Implantationsdosis und tiefer Diffusion und der zweite Dotierabschnitt durch Implantation eines Dotiermittels mit vergleichsweise hoher Implantationsdosis und flacher Diffusion ausgebildet ist.

Die Erfindung sieht wenigstens eine zweifache Implantation des Schutzrings vor; eine erste Implantation mit niedriger Dosis, aber tiefer Diffusion sorgt für ein gutes Durchbruchverhalten der Diode, eine daran anschließende zweite Implantation mit hoher Dosis, jedoch flacher Diffusion unterdrückt die Gefahr einer Ausbildung eines Kanals im Schutzring. Eine solche Kanalbildung (sogenanntes 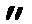 Channeling") ist unerwünscht, da dies zu ungünstigen Ausbeuten und im übrigen zu instabilen Neigungen der Diode führt. Die hohe und zugleich flache Dotierung bewirkt im Sperrfall der Diode eine Erniedigung der Spitzenfeldstärke und damit insgesamt eine höhere Durchbruchspannung der Diode. Diese Dotierung ist so eingestellt, daß die Durchbruchspannung im Schutzring höher liegt als bei der eigentlichen Schottkydiode, so daß die Durchbruchspannung insgesamt lediglich von der Schottkydiode bestimmt wird.

Bei einer besonders bevorzugten Ausbildung der Erfindung ist vorgesehen, daß sich der erste Dotierabschnitt bis zu einer Tiefe von etwa einem Drittel der Gesamttiefe des Halbleiterbereiches des ersten Leitungstyps und der zweite Dotierabschnitt ausgehend von der Hauptoberfläche des Halbleitersubstrates bis zu einer Tiefe von weniger als einem Fünftel bis einem Zehntel der Gesamtdicke des Halbleiterbereiches des ersten Leitungstyps erstreckt. Bei einer Gesamtdicke des Halbleiterbereiches des ersten Leitungstyps von etwa 4 bis 8 µm erstreckt sich der erste Dotierabschnitt vorzugsweise bis zu einer Tiefe von etwa 1 bis 3 µm, und der zweite Dotierabschnitt bis zu einer Tiefe von vorzugsweise etwa 1 µm in das Halbleitersubstrat. Hierbei kann insbesondere vorgesehen sein, daß der zweite Dotierabschnitt an der Hauptoberfläche des Halbleitersubstrats eine maximale Dotierung von etwa 10¹⁹ N·cm⁻³ und der erste Dotierabschnitt in einer Tiefe angrenzend zum zweiten Dotierabschnitt eine maximale Dotierung von etwa 10¹⁷ N·cm⁻³ besitzt.

Bei einer bevorzugten Ausführung kann vorgesehen sein, daß die maximale Dotierung des zweiten Dotierabschnittes um einen Faktor 100 größer ist als die maximale Dotierung des ersten Dotierabschnittes.

Bevorzugte Weiterführungen der Erfindung ergeben sich aus den Unteransprüchen.

Weitere Merkmale, Vorteile und Zweckmäßigkeiten der Erfindung ergeben sich aus der Beschreibung eines Ausführungsbeispieles anhand der Zeichnung. Es zeigt:
- Figur 1: eine schematische Schnittansicht einer Schottkydiode mit doppelter Schutzringimplantation;
- Figur 2: eine vergrößerte Teilansicht des Bereiches 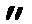 X" aus Figur 1; und
- Figur 3: eine schematische Ansicht des Dotierungsprofils des Schutzrings.

Das in der Zeichnung dargestellte Ausführungsbeispiel zeigt eine bezüglich einer Symmetrieachse S radialsymmetrisch ausgebildete Schottkydiodenanordnung 1 mit einem auf einem Silizium-Halbleitersubstrat 2 ausgebildeten Schottkykontakt 3 bestehend aus einem Dioden-Halbleiterbereich 4 eines ersten Leitungstyps, im dargestellten Fall eine n-leitende Siliziumepitaxieschicht 4 der Gesamtstärke t, und einer auf dem Halbleiterbereich 4 angrenzend angeordneten Metallschicht 5. Am Randbereich 6 des eine Durchbruchspannung von typischerweise 50 bis 70 V besitzenden Schottkykontaktes 3 ist eine Schutzstruktur 7 mit einem Dotierbereich 8 eines zweiten Leitungstyps entgegengesetzter Polarität zum ersten Leitungstyp, im dargestellten Fall vom p-leitenden Typ ausgebildet. Der Dotierbereich 8 erstreckt sich ausgehend von einer Hauptoberfläche 9 des Halbleitersubstrates 2 in eine vorbestimmte Tiefe t1 in das Halbleitersubstrat. Das Halbleitersubstrat 2 umfaßt ferner einen Bereich 10 aus n⁺-Silizium, dessen Rückseite mit einer Metallisierungsschicht 11 aus Gold oder Gold-Arsen versehen sein kann. Die Bezugsziffer 12 charakterisiert einen SiO₂-Bereich, die Bezugsziffer 13 eine darauf abgeschiedene Dielektrikumschicht, vorzugsweise aus Si₃N₄. Die Metallschicht 5 erstreckt sich in der dargestellten Weise bis zu einem Abschnitt oberhalb der Schichten 12 und 13. Die Herstellung einer solchen Silizium-Schottkydiode mit Hilfe einer Planartechnik zur Fertigung des Schottkykontaktes 3 mit dem Halbleiterbereich 4 und der Metallschicht 5, sowie dem Schutzring 7, und den Isolationsschichten 12 und 13 ist dem Fachmann hinlänglich bekannt und soll hier nicht im einzelnen dargestellt werden. Die Bezugsziffer 14 bezeichnet eine am äußersten Randbereich der Diode angeordnete Channelstop-Implantationsschicht, welche eine n-Anreicherungsimplantationsschicht darstellt und die Bildung eines störenden p-Kanals unterdrückt. Da die Implantationsschicht 14 für den erfindungsgemäßen Gegenstand unmittelbar keine Rolle spielt, und im übrigen dem Fachmann geläufig ist, soll diese an dieser Stelle ebenfalls nicht weiter erläutert werden.

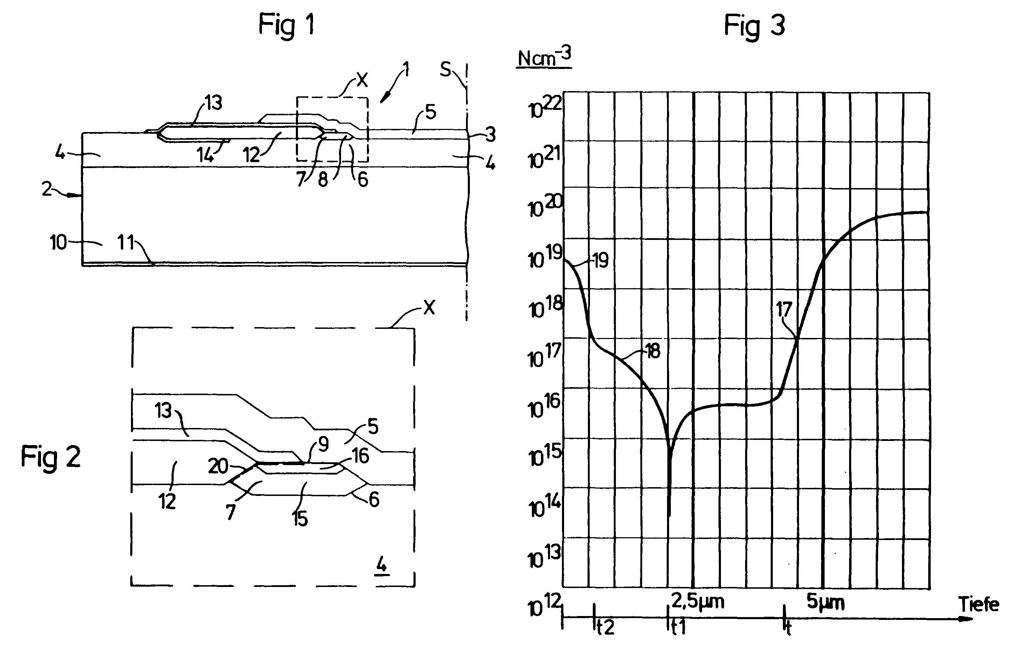

Figur 2 zeigt in einer vergrößerten Teilansicht nähere Einzelheiten der erfindungsgemäßen Schutzstruktur 7. Dessen Dotierbereich 8 besitzt zwei gegenüber der Hauptoberfläche 9 des Halbleitersubstrats 2 untereinander liegende, unterschiedliche Tiefe aufweisende erste und zweite Dotierabschnitte 15 und 16 jeweils vom p-Leitungstyp, wobei der erste Dotierabschnitt 15 bis zu einer größeren Tiefe t1 ausgebildet ist und eine vergleichsweise geringere Dotierung besitzt, und der zweite Dotierabschnitt 16 eine vergleichsweise hohe Dotierung besitzt und bis zu einer geringen Tiefe t2 angrenzend an die Hauptoberfläche 9 des Halbleitersubstrates 2 ausgebildet ist. Im dargestellten Fall beträgt die Gesamttiefe t der Epitaxieschicht 4 etwa 4 µm, die Gesamttiefe t1 des ersten Dotierabschnittes 15 etwa 2 µm, und die Gesamttiefe t2 des zweiten Dotierabschnittes 16 etwa 0,7 µm. Das Dotierungsprofil der Dotierabschnitte 15, 16, sowie der Epitaxieschicht 4 und des verbleibenden Bereiches 10 des Halbleitersubstrats 2 ergibt sich im einzelnen aus der schematischen Ansicht nach Figur 3. Im einzelnen besitzt das Dotierungsprofil drei zu unterscheidende Kurvenäste 17, 18 und 19. Der Kurvenast 17 gibt das Dotierungsprofil des mit Phosphor bzw. Arsen implantierten Epitaxiebereiches 4 bzw. übrigen Substratbereiches 10 wieder, der Kurvenast 18 zeigt das Dotierungsprofil des mit Bor implantierten ersten Dotierbereiches 8 der Schutzstruktur 7, und der Kurvenast 19 veranschaulicht das Dotierungsprofil des ebenfalls mit Bor implantierten zweiten Dotierabschnittes 16 der Schutzstruktur 7. Die beiden aufeinanderfolgend durchzuführenden Dotierungen des ersten und zweiten Dotierabschnittes werden so eingestellt, daß der erste Dotierabschnitt durch Implantation von Bor mit vergleichsweise geringer Implantationsdosis und tiefer Diffusion, und der zweite Dotierabschnitt durch Implantation von Bor mit vergleichsweise hoher Implantationsdosis und flacher Diffusion ausgebildet wird. Man erkennt aus dem Dotierungsprofil nach Figur 3, daß der zweite Dotierabschnitt 16 unmittelbar an der Hauptoberfläche 9 eine maximale Dotierung von etwa 10¹⁹ N·cm⁻³ besitzt, und mit zunehmender Tiefe stetig auf den Wert von etwa 10¹⁷ N·cm⁻³ abfällt, und insgesamt relativ flach ausgebildet ist, d.h. die maximale Tiefe t2 des zweiten Dotierabschnittes ist gegenüber der Gesamtdicke t der Epitaxieschicht sehr gering, etwa bis maximal 1 µm. Das Dotierungsprofil des ersten Dotierbereiches 15 beginnt mit etwa 10¹⁷ N·cm⁻³ in der Tiefe t2 und fällt stetig bis zur Tiefe t1 ab. Das Dotierungsprofil des ersten Dotierbereiches gewährleistet ein gutes Durchbruchverhalten der Schottkydiode. Gleichzeitig wird durch das dargestellte Dotierungsprofil des zweiten Dotierbereiches die unerwünschte Ausbildung eines Kanals an der in Figur 2 strichliert dargestellten Grenzfläche 20 zum Dielektrikum 12 bzw. 13 wirksam unterdrückt.

## Patentansprüche

1. Schottkydiodenanordnung mit einem auf einem Halbleitersubstrat (2) ausgebildeten Schottkykontakt (3) bestehend aus einem Halbleiterbereich (4) eines ersten Leitungstyps und einer auf dem Halbleiterbereich (4) angrenzend angeordneten Metallschicht (5), sowie einer am Randbereich (6) des Schottkykontaktes (3) ausgebildeten Schutzstruktur (7) mit einem im Halbleitersubstrat (2) ausgebildeten Dotierbereich (8) eines zweiten Leitungstyps entgegengesetzter Polarität zum ersten Leitungstyp, welcher Dotierbereich (8) sich ausgehend von einer Hauptoberfläche (9) des Halbleitersubstrates (2) in eine vorbestimmte Tiefe in das Halbleitersubstrat (2) erstreckt,
dadurch gekennzeichnet, daß
der Dotierbereich (8) der Schutzstruktur (7) wenigstens zwei gegenüber der Hauptoberfläche (9) des Halbleitersubstrats (2) untereinander liegende, unterschiedliche erste und zweite Dotierabschnitte (15, 16) aufweist, wobei der erste Dotierabschnitt (15) in größerer Tiefe ausgebildet ist und eine vergleichsweise geringere Dotierung besitzt, und der zweite Dotierabschnitt (16) eine vergleichsweise hohe Dotierung aufweist und bis zu einer geringen Tiefe angrenzend an die Hauptoberfläche (9) des Halbleitersubstrates (2) ausgebildet ist.

2. Schottkydiodenanordnung nach Anspruch 1, dadurch gekennzeichnet, daß der erste Dotierabschnitt (15) durch Implantation eines Dotiermittels mit vergleichsweise geringer Implantationsdosis und tiefer Diffusion und der zweite Dotierabschnitt (16) durch Implantation eines Dotiermittels mit vergleichsweise hoher Implantationsdosis und flacher Diffusion ausgebildet ist.

3. Schottkydiodenanordnung nach Anspruch 1 oder 2, dadurch gekennzeichnet, daß sich der erste Dotierabschnitt (15) bis zu einer Tiefe von etwa einem Drittel der Gesamttiefe des Halbleiterbereiches (4) des ersten Leitungstyps und der zweite Dotierabschnitt (16) ausgehend von der Hauptoberfläche (9) des Halbleitersubstrates (2) bis zu einer Tiefe von weniger als einem Fünftel bis einem Zehntel der Gesamtdicke des Halbleiterbereiches (4) des ersten Leitungstyps erstreckt.

4. Schottkydiodenanordnung nach Anspruch 3, dadurch gekennzeichnet, daß sich bei einer Gesamtdicke des Halbleiterbereiches (4) des ersten Leitungstyps von etwa 4 bis 8 µm der erste Dotierabschnitt (15) bis zu einer Tiefe von etwa 1 bis 3 µm und der zweite Dotierabschnitt (16) bis zu einer Tiefe von etwa 1 µm in das Halbleitersubstrat (2) erstreckt.

5. Schottkydiodenanordnung nach Anspruch 1 bis 4, dadurch gekennzeichnet, daß der zweite Dotierabschnitt (16) an der Hauptoberfläche (9) des Halbleitersubstrats (2) eine maximale Dotierung von etwa 10¹⁹ N·cm⁻³ und der erste Dotierabschnitt (15) in einer Tiefe angrenzend zum zweiten Dotierabschnitt (16) eine maximale Dotierung von etwa 10¹⁷ N·cm⁻³ besitzt.

6. Schottkydiodenanordnung nach Anspruch 1 bis 5, dadurch gekennzeichnet, daß die maximale Dotierung des zweiten Dotierabschnittes (16) um einen Faktor 100 größer ist als die maximale Dotierung des ersten Dotierabschnittes (15).

7. Schottkydiodenanordnung nach Anspruch 1 bis 6, dadurch gekennzeichnet, daß der Schottkykontakt (3) radialsymmetrisch ausgebildet ist, und die Schutzstruktur (7) am Randbereich (6) des Schottkykontaktes (3) einen Schutzring bildet.

8. Schottkydiodenanordnung nach Anspruch 1 bis 7, dadurch gekennzeichnet, daß das Halbleitersubstrat (2) Silizium aufweist und der Halbleiterbereich des ersten Leitungstyps des Schottkykontakts (3) eine n-leitende Epitaxieschicht darstellt.

9. Schottkydiodenanordnung nach Anspruch 1 bis 8, dadurch gekennzeichnet, daß der Dotierbereich (8) der Schutzstruktur (7) durch Implantation von Bor ausgebildet ist.

10. Schottkydiodenanordnung nach Anspruch 1 bis 9, dadurch gekennzeichnet, daß die Durchbruchspannung des Schottkykontaktes (3) etwa zwischen 50 und 70 V liegt.

11. Verfahren zur Herstellung einer Schottkydiodenanordnung mit einem auf einem Halbleitersubstrat (2) ausgebildeten Schottkykontakt (3) bestehend aus einem Halbleiterbereich (4) eines ersten Leitungstyps und einer auf dem Halbleiterbereich (4) angrenzend angeordneten Metallschicht (5), sowie einer am Randbereich des Schottkykontaktes (3) ausgebildeten Schutzstruktur (7) mit einem Dotierbereich (8) eines zweiten Leitungstyps entgegengesetzter Polarität zum ersten Leitungstyp, welcher Dotierbereich (8) sich ausgehend von einer Hauptoberfläche (9) des Halbleitersubstrates (2) in eine vorbestimmte Tiefe in das Halbleitersubstrat (2) erstreckt,
dadurch gekennzeichnet, daß
der Dotierbereich (8) der Schutzstruktur (7) durch wenigstens zwei gegenüber der Hauptoberfläche (9) des Halbleitersubstrats (2) untereinander liegende, unterschiedliche erste und zweite Dotierabschnitte (15, 16) ausgebildet wird, wobei der erste Dotierabschnitt (15) in größerer Tiefe ausgebildet wird und eine vergleichsweise geringere Dotierung besitzt, und der zweite Dotierabschnitt (16) eine vergleichsweise hohe Dotierung aufweist und bis zu einer geringen Tiefe angrenzend an die Hauptoberfläche (9) des Halbleitersubstrates (2) ausgebildet wird.

12. Verfahren nach Anspruch 11, dadurch gekennzeichnet, daß der erste Dotierabschnitt (15) durch Implantation eines Dotiermittels mit vergleichsweise geringer Implantationsdosis und tiefer Diffusion und der zweite Dotierabschnitt (16) durch Implantation eines Dotiermittels mit vergleichsweise hoher Implantationsdosis und flacher Diffusion ausgebildet wird.

13. Verfahren nach Anspruch 11 oder 12, dadurch gekennzeichnet, daß der erste Dotierabschnitt (15) bis zu einer Tiefe von etwa einem Drittel der Gesamttiefe des Halbleiterbereiches (4) des ersten Leitungstyps und der zweite Dotierabschnitt ausgehend von der Hauptoberfläche (9) des Halbleitersubstrates (2) bis zu einer Tiefe von weniger als einem Fünftel bis einem Zehntel der Gesamtdicke des Halbleiterbereiches (4) des ersten Leitungstyps hergestellt wird.

14. Verfahren nach Anspruch 13, dadurch gekennzeichnet, daß bei einer Gesamtdicke des Halbleiterbereiches (4) des ersten Leitungstyps von etwa 4 bis 8 µm der erste Dotierabschnitt bis zu einer Tiefe von etwa 1 bis 3 µm und der zweite Dotierabschnitt bis zu einer Tiefe von etwa 1 µm in das Halbleitersubstrat (2) hergestellt wird.

15. Verfahren nach Anspruch 11 bis 14, dadurch gekennzeichnet, daß der zweite Dotierabschnitt (16) an der Hauptoberfläche (9) des Halbleitersubstrats (2) mit einer maximalen Dotierung von etwa 10¹⁹ N·cm⁻³ und der erste Dotierabschnitt (15) angrenzend zum zweiten Dotierabschnitt (16) mit einer maximalen Dotierung von etwa 10¹⁷ N·cm⁻³ hergestellt wird.

16. Verfahren nach Anspruch 11 bis 15, dadurch gekennzeichnet, daß die maximale Dotierung des zweiten Dotierabschnittes (16) um einen Faktor 100 größer hergestellt wird als die maximale Dotierung des ersten Dotierabschnittes (15).

17. Verfahren nach Anspruch 11 bis 16, dadurch gekennzeichnet, daß der Schottkykontakt (3) radialsymmetrisch ausgebildet wird, und die Schutzstruktur (7) am Randbereich (6) des Schottkykontaktes (3) einen Schutzring bildet.

18. Verfahren nach Anspruch 11 bis 17, dadurch gekennzeichnet, daß das Halbleitersubstrat (2) Silizium aufweist und der Halbleiterbereich (4) des ersten Leitungstyps des Schottkykontakts (3) eine n-leitende Epitaxieschicht darstellt.

19. Verfahren nach Anspruch 11 bis 18, dadurch gekennzeichnet, daß der Dotierbereich (8) der Schutzstruktur (7) durch Implantation von Bor ausgebildet wird.

20. Verfahren nach Anspruch 11 bis 19, dadurch gekennzeichnet, daß die Durchbruchspannung des Schottkykontaktes (3) zu etwa zwischen 50 und 70 V eingestellt wird.
